# EUROPÄISCHE PATENTSCHRIFT

(11) **EP 2 209 621 B1**
(45) Veröffentlichungstag und Bekanntmachung des Hinweises auf die Patenterteilung: **14.12.2016**
(21) Anmeldenummer: 08838491.2
(22) Anmeldetag: 10.10.2008
(51) Int. Cl.: B32B 15/01, C22C 21/00, C23C 14/16, F16C 33/12, F16C 9/04

(54) **VERFAHREN ZUR HERSTELLUNG EINES GLEITLAGERELEMENTES MIT EINER BISMUTHALTIGEN GLEITSCHICHT, UND GLEITLAGERELEMENT**
METHOD FOR PRODUCING A SLIDING BEARING ELEMENT HAVING A BISMUTH-CONTAINING SLIDING LAYER, AND SLIDING BEARING ELEMENT
PROCÉDÉ DE PRODUCTION D'UN ÉLÉMENT DE PALIER LISSE PRÉSENTANT UNE COUCHE DE GLISSEMENT CONTENANT DU BISMUTH, ET ÉLÉMENT DE PALIER LISSE

(30) Priorität: 11.10.2007 AT 16352007
(43) Veröffentlichungstag der Anmeldung: 28.07.2010
(73) Patentinhaber: Miba Gleitlager GmbH, 4663 Laakirchen (AT)
(72) Erfinder: GÄRTNER, Walter, A-4810 Gmunden (AT); KRÄMER, Johann, 71229 Warmbronn (DE); SCHMIDT, Erwin, 73666 Baltmannsweiler (DE); WANG, Ping, 89075 Ulm (DE)
(74) Vertreter: Chmilewsky-Lehner, Robert
(86) Internationale Anmeldenummer: PCT/AT2008/000366
(87) Internationale Veröffentlichungsnummer: WO 2009/046476

(56) Entgegenhaltungen:
- EP-A- 0 940 474
- DE-A1- 3 729 414
- DE-B3-102004 045 110
- US-A- 5 286 445

## Beschreibung

Die Erfindung betrifft ein Verfahren zur Herstellung eines Gleitlagerelementes, nach dem auf einem Stützelement eine Gleitschicht durch Gasphasenabscheidung, gegebenenfalls nach Anordnung von zumindest einer Zwischenschicht, erzeugt wird, wobei die Gleitschicht eine Aluminiummatrix aufweist, in der neben Aluminium Bismut als Hauptbestandteil und gegebenenfalls Kupfer enthalten sind, wobei der Anteil an Bismut ausgewählt wird aus einem Bereich mit einer unteren Grenze von 10 Gew.-% und einer oberen Grenze von 45 Gew.-%, sowie ein Gleitlagerelement mit einem Stützelement, auf dem eine aus der Gasphase abgeschiedene Gleitschicht und gegebenenfalls zwischen dem Stützelement und der Gleitschicht zumindest eine Zwischenschicht angeordnet ist, wobei die Gleitschicht eine Aluminiummatrix aufweist, in der neben Aluminium Bismut unter Ausbildung einer Bismut enthaltenden Phase als Hauptbestandteil in einem Anteil, der ausgewählt ist aus einem Bereich mit einer unteren Grenze von 10 Gew.-% und einer oberen Grenze von 45 Gew.-%, und gegebenenfalls Kupfer enthalten sind.

Gleitschichten von Gleitlagern wurden in der Vergangenheit üblicherweise mit Blei als Weichphasenelement legiert, um der Gleitschicht einerseits die gewünschte Selbstschmierfähigkeit und andererseits die Einbettfähigkeit für Fremdpartikel aus dem Abrieb zu geben. Daneben wurden im Laufe der Zeit auch Gleitschichten mit Zinn als Weichphasenelement entwickelt, wobei Zinn im Hinblick auf seine Eigenschaften dem Blei unterlegen ist, da es einen niedrigeren Schmelzpunkt als Blei aufweist.

Blei ist bekanntlich toxisch und verursacht somit Umweltprobleme, weswegen dessen Verwendung immer mehr in den Hintergrund gerückt wird bzw. durch entsprechende Gesetze oder Vorschriften in der Automobilbranche oder Motorenindustrie verboten ist.

In der älteren Patentliteratur ist auch Bismut immer wieder genannt als teilweiser Ersatz für Zinn oder Blei. Bismut hat einen Schmelzpunkt, der zwischen dem von Zinn und Blei liegt, und ist daher in Hinblick auf Anwendungen in Hochleistungsmotoren interessant.

Beispielsweise beschreibt die DE 32 49 133 C ein Verfahren zum Herstellen einer Legierung auf Aluminiumbasis für Verbundlager mit 0,5 bis 11 Gew.-% mindestens eines Hartelementes aus der Gruppe Silizium, Mangan, Eisen, Molybdän, Nickel, Zirkonium, Kobalt, Titan, Antimon, Chrom und Niob, wobei der Rest aus Aluminium und unvermeidbaren Verunreinigungen besteht, durch Schmelzen, Gießen, ein- oder mehrfaches Walzen mit Zwischenglühen, wobei zur Erzeugung von im Wesentlichen kugelförmigen Hartteilchen, die einen größten Durchmesser im Bereich von 5 bis 40 µm aufweisen und in einer Flächenkonzentration von mindestens fünf Teilchen pro 3,56 x 10⁻²mm² in jedem beliebigen Teil der Legierung vorhanden sind, die Legierung nach dem letzten Walzen vor dem Druckverschweißen mit Stahlstützschalen in einem Temperaturbereich von über 350 bis 550 °C mindestens eineinhalb Stunden geglüht und anschließend mit einer Geschwindigkeit mit weniger als 200 °C pro Stunde abgekühlt wird. Diese Legierung enthält 1 bis 35 Gew.-% Zinn und 0,1 bis 10 Gew.-% mindestens eines der Elemente Blei, Kadmium, Indium, Thallium und Bismut.

Aus der DE 36 40 698 C ist ein Verfahren zur Herstellung einer Lagerlegierung auf Aluminiumbasis bekannt, die wenigstens aus einem aus der Gruppe, Blei, Zinn, Indium, Antimon und Bismut ausgewählten Schmierungselemente in einer Gesamtmenge von mehr als 0,04 aber nicht mehr als 0,07 Querschnittsflächenanteil an der Gesamtquerschnittsfläche, sowie aus Silizium als hartem Element in einer Menge von 0,01 bis 0,17 Querschnittsflächenanteil, ferner als 0,2 bis 5 Gew.-% wenigstens eines aus der Gruppe Kupfer, Chrom, Magnesium, Mangan, Nickel, Zinn und Eisen ausgewählten Verstärkungselementes, sowie aus 0 bis 3 Gew.-% wenigstens eines Kornfeinerungselementes, ausgewählt aus einer Titan, Bor, Zirkonium, Vanadium, Gallium, Scandium, Yttrium, sowie Elemente der Seltenen Erden der Atomnummern 51 bis 71 umfassenden Gruppe und aus Aluminium als Rest besteht, wobei die Korngröße des wenigstens einen Schmierungselementes nicht größer als 8 µm und die Korngröße des Silizium nicht größer als 12 µm und wobei die Zugfestigkeit der Legierung bei Normaltemperatur nicht geringer als 117 N/mm² und die Dehnung bei Normaltemperatur nicht geringer als 11 % ist. Diese Lagerlegierung wird hergestellt durch Erwärmen eines Pulvers einer ersten Legierung auf Aluminiumbasis, die aus 8 bis 12 Gew.-%, 0,4 bis 1,8 Gew.-% Zinn, 1 bis 15 Gew.-% Silizium, 0,2 bis 5 Gew.% zumindest eines Verstärkungselementes, ausgewählt aus einer Kupfer, Chrom, Magnesium, Mangan, Zink und Eisen umfassenden Gruppe und Aluminium als Rest besteht, bei einer Temperatur im Bereich von 350 bis 550 °C bis die Siliziumkörner in dem Legierungspulver auf 6 bis 12 µm wachsen, vermischen des ersten Legierungspulver auf Aluminiumbasis nach der Erwärmungsstufe mit einem Pulver einer zweiten Legierung auf Aluminiumbasis, die mindestens ein Schmierungsmittel enthält, das aus der Gruppe ausgewählt ist, die aus Blei, Zinn, Indium und Antimon und Bismut besteht, sodass die resultierende Legierungspulvermischung die gleich chemische Zusammensetzung wie die herzustellende Lagelegierung aufweist, Pressen der Legierungspulvermischung zu einem Baren- und Fließpressen des Barens bei einem Fließpressverhältnis von nicht weniger als 10.

Die DE 37 29 414 A beschreibt einen Schichtwerkstoff für Gleitlagerelemente, z.B. Radialgleitlager bzw. Axialgleitlager, bestehend aus einer metallischen Stützschicht und einer auf der Stützschicht angebrachten Antifriktionsschicht aus Lagerwerkstoff auf Aluminiumbasis, gegebenenfalls versehen mit einer aufgebrachten Bindungsschicht und Anpassungsschicht, wobei der Lagerwerkstoff eine nahezu homogene Aluminiumlegierung ist, die in dem Aluminium mit den üblichen zulässigen Verunreinigungen 1 bis 3 % Massenanteile Nickel, 0,5 bis 2,5 % Massenanteile Mangan und 0 bis 2 Massenanteile Blei enthält und Hartteilchen aus Nickel und Mangan bzw. nickelhaltige bzw. manganhaltige Hartteilchen aufweisen kann, deren Teilchengröße im Wesentlichen kleiner gleich 5 µm beträgt, wobei die den Lagerwerkstoff bildende Aluminiumlegierung einen Bismutzusatz zwischen 0,1 und 2 % Massenanteilen enthält. Es sollen damit die Herstellbarkeit und die Verarbeitbarkeit durch spanende Oberflächenbearbeitung und die Gleiteigenschaften, insbesondere die Notlaufeigenschaften des für die Anitfriktionsschicht vorgesehenen Lagerwerkstoffes verbessert werden.

Obwohl es also bekannt war, Bismut als Zusatz zu Lagerlegierungen bzw. als Friktionsschichten vorzusehen, sind bislang hierzu keine Produkte auf dem Markt erhältlich, was wahrscheinlich daran liegt, dass Bismut spröde und somit schwer zur verarbeiten ist. Erst in jüngster Zeit taucht Bismut- nicht zuletzt wegen der beschriebenen Bleiproblematik - in der Verwendung in Gleitlagern wieder auf.

So beschreibt z.B. die DE 100 32 624 C ein Gleitlager, welches einen Lagermetall und eine auf dem Lagermetall ausgebildete Laufschicht aus Bismut oder einer Bismutlegierung umfasst, wobei die Bismutkristallite in dieser Schicht eine bestimmte Orientierung, ausgedrückt durch die Röntgenbeugungsstärken, einnehmen. Diese Bismut bzw. Bismutlegierungsschicht wird durch Elektroplattierung hergestellt. Es soll damit die Ermüdungsfestigkeit und Kompatibilität, die für eine Laufschicht eines Gleitlagers erforderlich sind, verbessert werden.

Die DE 10 2004 025 560 B4 beschreibt ein Gleitteil, welches eine Lagerlegierungsschicht und eine Auflageschicht, welche auf der Lagerlegierungsschicht ausgebildet ist, umfasst, wobei die Auflageschicht aus einer bismutbasierten Legierung hergestellt ist, welche Kupfer mit 0,1 bis 10 Gew.-% und Zinn und/oder Indium mit insgesamt 0,5 bis 10 Gew.-% umfasst.

Die DE 10 2004 045 110 B3 beschreibt eine Gleitschicht für Gleitlager, insbesondere für Kurbelwellen oder Pleuellager, aus einer Legierung mit mehreren Phasen, die eine Matrix und eine disperse Phase ausbilden, wobei die disperse Phase nur eine geringe Löslichkeit im Metall der Matrix aufweist, wobei die Metallmatrix durch eine Aluminiumlegierung und die disperse Phase durch Bismut oder eine hochschmelzende Bismutlegierung gebildet ist sowie ein Sputter-Verfahren zur Herstellung. Der Bismutgehalt in der gesamten Gleitschicht kann zwischen 10 und 40 Gew.-% betragen, wobei Bismut oder die Bismutlegierung so fein verteilt vorliegen, dass sie röntgenamorph sind oder dass deren Primärphasen lichtmikroskopisch nicht erkennbar sind. Mit Ausnahme des Hinweises auf ein Eutektikum im Bismut-Aluminium-System lässt diese DE-B allerdings offen, wie diese Feinkörnigkeit erzielt wird.

Die DE 10 2004 055 228 A1 beschreibt eine Lagerschale eines Pleuels, die im großen Pleuelauge angeordnet ist, wobei die Lagerschale aus mehreren thermisch gespritzten Schichten und die oberste Materialschicht der Lagerschale im Wesentlichen aus einer Aluminium/Bismut-Legierung gebildet ist. Ebenso kann die gesamte Lagerschale im Wesentlichen aus einer thermisch gespritzten Schicht einer Alumium-Bismut-Legierung gebildet sein. Wiederum wird darin beschrieben, dass Bismut so fein verteilt vorliegen soll, dass es röntgenamporph ist, bzw. die Primärphasen nicht lichtmikroskopisch erkennbar sind. Der Bismutgehalt der Aluminium-Bismut-Legierung kann zwischen 10 und 40 Gew.-% betragen. Dieses sehr feine Gefüge mit definierter disperser Phase aus Bismut bzw. einer Bismutlegierung wird durch sehr schnelles Abkühlen nach der Bildung bei erhöhter Temperatur erreicht. Dies hat jedoch den Nachteil, dass der Verfahrensablauf selbst nur bedingt kontrolliert werden kann, indem versucht wird, mehr oder weniger genau diese hohen Abkühlraten einzustellen.

Schließlich beschreibt die DE 10 2005 050 374 A ein Verfahren zur Herstellung einer Gleitschicht, die aus einer Aluminiumlegierung mit dem wesentlichen Legierungsbestandteil Bismut und/oder Zinn, Kupfer und Silizium besteht, mittels PVD, CVD oder Sputtern, durch Abscheidung der Legierungsbestandteile aus der Gasphase in feinkristalliner oder amorpher Form auf ein Substrat, Wärmebehandlung der abgeschiedenen Schicht, wobei Temperatur und Dauer der Wärmebehandlung so gewählt werden, dass eine Rekristallisation und ein Kornwachstum des Siliziums stattfinden und so grobkristalline Siliziumausscheidungen gebildet werden. Es sollen damit die Druck-, Temperatur- und Langzeitstabilitäts-Anforderungen von Gleitschichten verbessert werden, insbesondere eine geringe Verschleißrate erzielt werden, sowie ein kostengünstiges Herstellungsverfahren möglich sein. Wesentlich für diese Gleitschicht ist, dass die Silizium-Ausscheidungen grob kristallin vorliegen und dass Bismut nicht wie Silizium als Hartstoff, sondern als Gleitstoff wirkt. Der Bismutgehalt kann zwischen 10 und 35 Gew.-% betragen. Auch diese DE-A lässt offen, wie diese feindisperse Verteilung der Bismutphase erreicht wird. Insbesondere stellt dabei auch die Wärmebehandlung zur Kornvergrößerung des Siliziums, im Hinblick auf die Kornfeinheit des Bismuts, ein Problem dar.

Es ist daher Aufgabe der vorliegenden Erfindung ein Verfahren zur Herstellung einer Gleitschicht eines Gleitlagerelementes mit einem Bismutanteil anzugeben, welche eine hohe Verschleißfestigkeit aufweist.

Diese Aufgabe der Erfindung wird durch das eingangs genannte Verfahren zur Herstellung eines Gleitlagerelementes gelöst, bei dem durch die Gasphasenabscheidung von zumindest einem Element, dessen Schmelzpunkt um zumindest 950 °C höher ist, als jener des Bismuts und/oder durch Anlegen einer Bias-Spannung an das Stützelement die Bismut-Keimdichte erhöht wird, wobei das zumindest eine Element aus einer Gruppe umfassend Molybdän, Nickel, Chrom, Eisen, Hafnium, Kohlenstoff, Niob, Iridium, Osmium, Rhenium, Rhodium, Ruthenium, Tantal, Vanadium, Wolfram, Technetium und Titan ausgewählt wird, sowie unabhängig hiervon durch das Gleitlagerelement, bei dem die Bismut enthaltende Phase eine Korngröße aufweist, die ausgewählt ist aus einem Bereich mit einer unteren Grenze von 50 nm und einer oberen Grenze von 3 µm und dass das zumindest eine Element aus einer Gruppe umfassend Molybdän, Nickel, Chrom, Eisen, Hafnium, Kohlenstoff, Niob, Iridium, Osmium, Rhenium, Rhodium, Ruthenium, Tantal, Vanadium, Wolfram, Technetium und Titan ausgewählt ist.

Von Vorteil ist dabei, dass durch die Erhöhung der Keimdichte des Bismuts ein feineres Gefüge erreicht werden kann, wodurch auch die Rauhigkeit der Schicht reduziert werden kann und in der Folge die Verschleißfestigkeit dieser Gleitschicht erhöht ist. Dies kann zum einen dadurch erreicht werden, dass ein Element zugegeben wird, welches eine sehr geringe Mobilität aufweist und somit das Bismut in seiner Beweglichkeit hindert, wie beispielsweise Molybdän, - die geringe Beweglichkeit wird auch vor allem deswegen erreicht, dass hochschmelzende Elemente zugesetzt werden - oder durch ein Element, das eine gewisse Affinität zu Bismut aufweist, wodurch eine Erhöhung der Keimplätze erreicht werden kann bzw. durch das Anlegen einer Bias-Spannung an das Stützelement, sodass in der Folge die Anzahl der Gitterfehler der abgeschiedenen Schicht erhöht wird und damit mehr aktive Zentren vorhanden sind, an denen Bismut aufkristallisieren kann.

Das zumindest eine Element, welches der Aluminiummatrix zugesetzt wird, ist ausgewählt aus einer Gruppe umfassend Molybdän, Nickel, Chrom, Eisen, Hafnium, Kohlenstoff, Niob, Iridium, Osmium, Rhenium, Rhodium, Ruthenium, Tantal, Vanadium, Wolfram, Technetium und Titan. Diese Elemente sind zum Teil hochschmelzend, wodurch sie die Beweglichkeit von Bismut, d.h. dessen Oberflächendiffusion während der Herstellung des Gleitlagerelementes, sehr stark behindern, und damit die Keimdichte entsprechend hoch eingestellt werden kann.

Durch die hohe Keimdichte ist es möglich, Bismutanteile in der Gleitschicht zu verwirklichen bis zu einer oberen Grenze von 45 Gew.-%. Der Anteil an Bismut in der Gleitschicht beträgt zwischen 10 Gew.-% und 45 Gew.-%. Durch diese hohen Anteile an Bismut in der Gleitschicht wird die Verwendung von Bismut für diesen Zweck als Ersatz für Blei und Zinn deutlich verbessert.

Die Bismut enthaltende Phase weist eine Korngröße auf, die ausgewählt ist aus einem Bereich mit einer unteren Grenze von 50 nm und einer oberen Grenze von 3 µm. Im Wesentlichen ist dies eine Folge der nachfolgend ausgeführten, bevorzugten Keimdichte, wodurch sich die angesprochene Verschleißfestigkeit verbessern lässt. Durch die Steigerung des Mengenanteils des Elementes mit dem höheren Schmelzpunkt als Bismut lässt sich die Korngröße der Bismutphase reduzieren bzw. durch Verringerung dieses Mengenanteils erhöhen. Es können also mit höheren Mengenanteilen an dem Elemente mit dem höheren Schmelzpunkt als Bismut sehr feine Schichten erreicht werden.

Die Bismut enthaltende Phase kann auch eine Korngröße aufweisen, die ausgewählt ist aus einem Bereich mit einer unteren Grenze von 250 nm und einer oberen Grenze von 2 µm, insbesondere ausgewählt aus einem Bereich mit einer unteren Grenze von 500 nm und einer oberen Grenze von 1,5 µm.

Vorzugsweise wird ein Element zugegeben, dessen Schmelzpunkt um zumindest 1500 °C höher ist, als jene des Bismuts, insbesondere ein Element dessen Schmelzpunkt um 2000 °C höher ist als jene des Bismuts.

Von Vorteil ist dabei, wenn eine Bismut-Keimdichte erzeugt wird, die ausgewählt ist aus einem Bereich mit einer unteren Grenze von 4.10⁶ Keime/cm² und einer oberen Grenze von 2,5.10⁹ Keime/cm², da sich im Zuge der Erfindung herausgestellt hat, dass eine Keimdichte aus diesem Bereich zu einer besonderen Verbesserung der Verschleißfestigkeit geführt hat.

Die Bismut Keimdichte kann auch ausgewählt sein aus einem Bereich mit einer unteren Grenze von 4.10⁶ Keime/cm² und einer oberen Grenze von 2.10⁸ Keime/cm², bzw. einem Bereich mit einer unteren Grenze von 8.10⁶ Keime/cm² und einer oberen Grenze von 6.10⁷ Keime/cm².

Dies trifft auch zu, wenn die Bias-Spannung am Stützelement ausgewählt ist aus einem Bereich mit einer unteren Grenze von - 20 V und einer oberen Grenze von - 150 V.

Die Bias Spannung kann auch ausgewählt werden aus einem Bereich mit einer unteren Grenze von - 30 V und einer oberen Grenze von - 120 V, bzw. aus einem Bereich mit einer unteren Grenze von - 45 V und einer oberen Grenze von - 100 V.

Insbesondere im Zusammenwirken des zugesetzten Elementes mit der angelegten Biasspannung konnten diese Effekte noch verbessert werden.

Das zumindest eine Element mit dem höheren Schmelzpunkt als Bismut wird der Gasphase vorzugsweise gleichzeitig mit dem Bismut zugesetzt, da damit durch die Steuerung des Targets aus dem Element die Abscheidemenge des Elementes variiert werden kann, wodurch ein direkter Einfluss auf die Anzahl der Keime, d.h. die Keimdichte, genommen werden kann.

Es ist weiters von Vorteil, wenn das zumindest eine Element mit dem höheren Schmelzpunkt als Bismut in einer Konzentration der Gasphase zugesetzt wird, die ausgewählt ist aus einem Bereich mit einer unteren Grenze von 0,5 % und einer oberen Grenze von 10 %. Mit diesen Konzentrationen an diesem Element sind hohe Konzentration an Bismut verwirklichbar mit entsprechend positiven Eigenschaften hinsichtlich der Verschleißfestigkeit dieser Schicht, sowie der Gleiteigenschaften an sich.

Das zumindest eine Element mit dem höheren Schmelzpunkt als Bismut kann auch in einer Konzentration der Gasphase zugesetzt werden, die ausgewählt ist aus einem Bereich mit einer unteren Grenze von 2 % und einer oberen Grenze von 7,5 %, insbesondere ausgewählt aus einem Bereich mit einer unteren Grenze von 3,25 % und einer oberen Grenze von 6,15 %.

Es ist weiters möglich, dass das Kupfer, welches gegebenenfalls der Aluminiummatrix zugesetzt wird zur Bildung von Hartphasen und damit zur Matrixverstärkung, zumindest teilweise durch das zumindest eine Element mit höheren Schmelzpunkt als Bismut ersetzt wird, da somit dieses Element nicht nur zur Kornverfeinerung beiträgt, sondern auch zur Verstärkung der Matrix an sich. Insbesondere betrifft dies Elemente, welche mit Bismut intermetallische Phasen ausbilden können, beispielsweise Nickel, dessen matrixverfestigende Eigenschaften für Aluminium an sich bereits aus dem Stand der Technik bekannt sind. Es ist damit also im Vergleich zur herkömmlichen Aluminiummatrixlegierungen, die kein Bismut enthalten, diesbezüglich nur eine geringfügige Abänderung der Legierungen erforderlich.

Es ist im Rahmen der Erfindung möglich, dass der Anteil von Bismut ausgewählt ist aus einem Bereich mit einer unteren Grenze von 20 Gew.-% und einer oberen Grenze von 45 Gew.-% bzw. ausgewählt ist aus einem Bereich mit einer unteren Grenze von 25 Gew.-% und einer oberen Grenze von 45 Gew.-%.

Des Weiteren ist es möglich, den Anteil an Kupfer auszuwählen aus einem Bereich mit einer unteren Grenze von 0,5 Gew.-% und einer oberen Grenze von 5 Gew.-% um eine ausreichende Matrixverfestigung der Aluminiummatrix zu erreichen und somit die Härte dieser Gleitschicht entsprechend anpassen zu können. Dabei ist es im Rahmen der Erfindung möglich, dass der Anteil an Kupfer ausgewählt ist aus einem Bereich mit einer unteren Grenze von 1 Gew.-% und einer oberen Grenze von 2,5 Gew.-%, wobei in diesem letztgenannten Bereich die Eigenschaften der Gleitschicht im Hinblick auf Verschleißbeständigkeit und Gleitfähigkeit besonders ausgeprägt sind.

Der Anteil an dem zumindest einem Element ist bevorzugt ausgewählt aus einem Bereich mit einer unteren Grenze von 0,5 Gew.-% und einer oberen Grenze von 10 Gew.-%, mit der Maß gabe, dass die Summe an mehreren Elementen aus dieser Gruppe nicht mehr als 15 Gew.-% beträgt. Unterhalb der angegebenen Grenze konnte keine ausreichende Erhöhung der Bismut-keimdichte beobachtet werden, sodass die Verbesserung der Verschleißbeständigkeit nur unzureichend war. Oberhalb der angegebenen Grenze zeigten weitere Zusätze an zumindest einem dieser Elemente keine weitere Verbesserung der Verschleißbeständigkeit und bewirkte lediglich die Verringerung des Bismutgehaltes bzw. eine übermäßige Erhöhung der Härte der Gleitschicht, wodurch die Gleiteigenschaften der Gleitschicht verschlechtert wurden.

Insbesondere wird der Anteil an dem zumindest einen Element, ausgewählt aus einem Bereich mit einer unteren Grenze von 2,5 Gew.-% und einer oberen Grenze von 8 Gew.-%, vorzugsweise aus einem Bereich mit einer unteren Grenze von 3,25 Gew.-% und einer oberen Grenze von 7,15 Gew.-%.

Die Gleitschicht weist bevorzugt eine Schichtdicke auf, die ausgewählt ist aus einem Bereich mit einer unteren Grenze von 10 µm und einer oberen Grenze von max. 150 µm. Schichtdicken unterhalb dieser Grenze können, insbesondere wenn die Korngröße der Bismutkristallite im unteren Bereich des oben angegebenen Bereiches liegt, unter Umständen eine Verschlechterung der Verschleißbeständigkeit durch zu raschen Abrieb bewirken. Schichtdicken oberhalb des angegebenen Bereiches sind zwar teilweise prinzipiell noch anwendbar, allerdings kann es dabei auch auftreten, dass der Zusammenhalt der Gleitschicht verschlechtert wird und somit ein vorzeitiger Verschleiß eintritt.

Insbesondere wird gemäß einer Ausführungsvariante eine Schichtdicke der Gleitschicht hergestellt, die ausgewählt ist aus einem Bereich mit einer unteren Grenze von 12 µm und einer oberen Grenze von 80 µm, vorzugsweise aus einem Bereich mit einer unteren Grenze von 20 µm und einer oberen Grenze von 30 µm.

Im Rahmen der Erfindung ist es weiters von Vorteil, wenn die Gleitschicht eine Härte nach Vickers aufweist, die ausgewählt ist aus einem Bereich mit einer unteren Grenze von 50 UMHV(3 pond) und einer oberen Grenze von 250 UMHV(3 pond). Besonders Gleitschichten mit Härten aus diesem Bereich haben sich als Ersatz von bleihältigen Gleitschichten günstig erwiesen. Sinkt die Härte der Gleitschicht unterhalb des angegebenen Bereiches ab, so weist die Gleitschicht nicht mehr die gewünschte Verschleißbeständigkeit auf. Weist hingegen die Gleitschicht eine Härte oberhalb des angegebenen Wertes auf, ist diese damit zu hart, wodurch zwar die Verschleißbeständigkeit der Gleitschicht besser ist, allerdings damit ein erhöhter Abrieb an dem zu lagernden Bauteil beobachtet werden kann und insbesondere auch die Laufeigenschaften unter Mangelschmierung verschlechtert sind.

Insbesondere kann die Härte nach Vickers ausgewählt sein aus einem Bereich mit einer unteren Grenze von 70 UMHV (3 pond) und einer oberen Grenze von 230 UMHV (3 pond), vorzugsweise aus einem Bereich mit einer unteren Grenze von 85 UMHV (3 pond) und einer oberen Grenze von 200 UMHV (3 pond).

Die Härteangaben beziehen sich auf eine Vickers-Ultramikrohärtemessung mit einer Prüfkraft von 3 Pond in Anlehnung an die Norm DIN EN ISO 6507-1.

Wegen der Feinkörnigkeit der Bismutkristallite bzw. der Kristallite von Bismutphasen kann der Umstand eintreten, dass das Bismut verstärkt in darunter liegende Schichten aufgrund der Temperaturbelastung von Gleitlagerelementen diffundiert. Für diesen Fall ist es von Vorteil, wenn als Diffusionssperrschicht zwischen der Gleitschicht und einer darunter liegenden Lagermetallschicht eine Schicht aus Stahl, insbesondere Edelstahl, angeordnet wird, da derartige Diffusionssperrschichten im Vergleich zu herkömmlichen Diffusionssperrschichten aus Eisen oder Nickel durch Vermeidung der Bildung von intermetallischen Phasen mit dieser Diffusionssperrschicht eine bessere Wirkung zeigen.

Zum besseren Verständnis der Erfindung wird diese anhand der nachfolgenden Figuren und Ausführungsbeispiele näher erläutert.

Es zeigen dabei jeweils in stark schematisch vereinfachter Darstellung:
- Fig. 1: ein Gleitlagerelement in Form einer Gleitlagerhalbschale bzw. Vollschale;
- Fig. 2: die Direktbeschichtung eines Pleuelauges eines Pleuels.

Einführend sei festgehalten, dass in den unterschiedlich beschriebenen Ausführungsformen gleiche Teile mit gleichen Bezugszeichen bzw. gleichen Bauteilbezeichnungen versehen werden, wobei die in der gesamten Beschreibung enthaltenen Offenbarungen sinngemäß auf gleiche Teile mit gleichen Bezugszeichen bzw. gleichen Bauteilbezeichnungen übertragen werden können. Auch sind die in der Beschreibung gewählten Lageangaben, wie z.B. oben, unten, seitlich usw. auf die unmittelbar beschriebene sowie dargestellte Figur bezogen und sind bei einer Lageänderung sinngemäß auf die neue Lage zu übertragen.

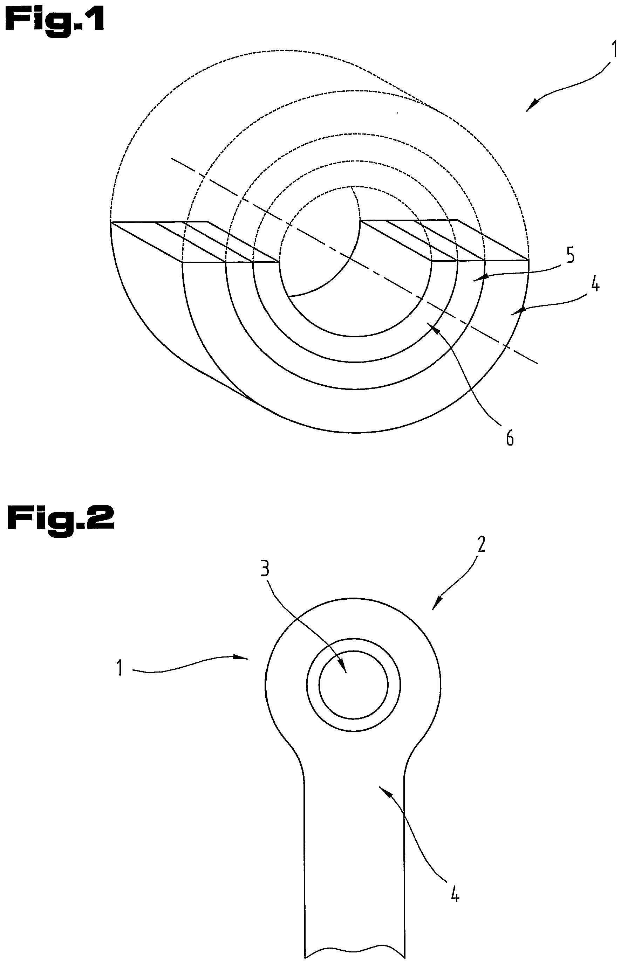

Fig. 1 zeigt ein erfindungsgemäßes Gleitlagerelement 1 in Form einer Gleitlagerhalbschale.

Es sei bereits an dieser Stelle erwähnt, dass die Erfindung nicht auf Gleitlagerelemente 1 in Form von Gleitlagerhalbschalen beschränkt ist, sondern vielmehr auch andere Gleitlagerelemente 1 mit umfasst sind, wie z.B. Anlaufringe, Vollschalenlagerelemente, wie dies in Fig. 1 strichliert angedeutet ist, Lagerbuchsen, ebenso wie direkt beschichtete Anwendungen, wie z.B. Pleuellager 2, d.h. eine Pleuelauge 3, wie dies in Fig. 2 dargestellt ist, etc. Die Gleitlagerelemente 1 können als Radial- oder Axiallager ausgeführt sein.

Das Gleitlagerelement 1 nach Fig. 1 ist aus einem Stützelement 4 bzw. einer Stützschale, einer Lagermetallschicht 5 sowie einer Gleitschicht 6 aufgebaut. Das Stützelement 4 besteht üblicherweise aus Stahl, kann aber selbstverständlich auch aus vergleichbaren Werkstoffen bestehen, mit welchen die selbe bzw. eine ähnliche Funktion, nämlich die Bereitstellung der mechanischen Festigkeit des Gleitlagerelementes 1, realisiert werden kann. Die mechanische Festigkeit des gesamten Gleitlagerelementes 1 ist dabei abhängig vom jeweiligen Einsatzgebiet, sodass beispielsweise auch verschiedenste Kupferlegierungen, wie z.B. Messing, Bronzen, Verwendung finden können. Zudem wird durch das Stützelement 4 eine gewisse Formstabilität gewährleistet.

Es sei darauf hingewiesen, dass es im Rahmen der Erfindung nicht zwingend notwendig ist, dass zwischen der Gleitschicht 6 und dem Stützelement 4 eine Lagermetallschicht 5 angeordnet ist, sondern kann vielmehr die Gleitschicht 6 direkt auf dem Stützelement 4 angeordnet werden. Beispielsweise ist dies der Fall, wenn z.B. Pleuellager 2 direkt beschichtet werden, also das Pleuelauge 3 einer Pleuelstange.

Als Lagermetallschicht 5 kommen prinzipiell sämtliche für derartige Gleitlagerelemente 1 aus dem Stand der Technik bekannte Lagermetalle in Frage, wobei diese bevorzugt bleifrei sind. Beispiele hierfür sind:
1. Lagermetalle auf Aluminiumbasis (zum Teil nach DIN ISO 4381 bzw. 4383): AlSn6CuNi, AlSn20Cu, AlSi4Cd, AlCd3CuNi, AlSi11Cu, AlSn6Cu, AlSn40, AlSn25CuMn, AlSil1CuMgNi, AlZn4,5;
2. Lagermetalle auf Kupferbasis (zum Teil nach DIN ISO 4383): CuSn10, CuAl10Fe5Ni5, CuZn31Si, CuSn8Bi10, CuSn2,5-11Zn0,5-5, z.B. CuSn4,5Zn;

Des Weiteren ist es möglich, wie dies bereits aus dem Stand der Technik bekannt ist, zwischen den einzelnen Lagen bzw. zumindest einzelnen Schichten, also beispielsweise dem Stützelement 4 und der Lagermetallschicht 5 und/oder der Lagermetallschicht 5 und/oder der Gleitschicht 6 zumindest eine Zwischenschicht in Form einer Bindeschicht oder aber auch als Diffusionssperrschicht anzuordnen, um das Diffundieren einzelner Bestandteile aufgrund der Wärmebelastung des Gleitlagerelementes 1 aus einer Schicht in eine andere Schicht, und damit die Verarmung einer Schicht an diesem Element, zu verhindern, bzw. um die Haftfestigkeit der einzelnen Schichten aneinander zu verbessern. Als Bindeschichten kommen beispielsweise Schichten aus Reinaluminium oder Aluminiumlegierungen, beispielsweise Legierungen von Aluminium mit Scandium in Betracht. Diffusionssperrschichten können beispielsweise durch Nickel-, Kupfer- oder Silberschichten gebildet sein. Besonders bevorzugt in Hinblick auf das Vorhandensein von Bismut wird eine Diffusionssperrschicht aus Stahl, insbesondere Edelstahl, verwendet.

Diese Binde- bzw. Diffusionssperrschichten weisen üblicherweise eine geringe Schichtdicke von 1 bis 3 µm auf.

Die Lagermetallschicht 5 kann eine Schichtdicke aufweisen, ausgewählt aus einem Bereich mit einer unteren Grenze von 100 µm und einer oberen Grenze von 1 mm, das Stützelement 4 kann eine Schichtdicke aufweisen ausgewählt aus einem Bereich mit einer unteren Grenze von 1 mm und einer oberen Grenze von 7 mm.

Erfindungsgemäß ist nunmehr vorgesehen, dass die Gleitschicht 6 aus einer Aluminiumbasislegierung mit einer Aluminiummatrix gebildet ist, in der neben Aluminium Bismut den Hauptbestandteil dieser Legierung bildet. Gegebenenfalls kann zur Matrixfestigung auch Kupfer enthalten sein.

Das Gleitlagerelement 1 ist insbesondere bleifrei, d.h. dass weder in der Lagermetallschicht 5 noch in der Gleitschicht 6 Blei enthalten ist. Mit bleifrei im Sinne der Erfindung ist gemeint, dass kein zusätzliches Blei zugesetzt wird, Blei jedoch aufgrund von Verunreinigungen aus den Herstellungsverfahren der einzelnen eingesetzten Elemente in Spuren vorhanden sein kann, sofern nicht ohnehin hochreine Elemente eingesetzt werden.

Die Herstellung der Gleitschicht 6, d.h. der Abscheidung auf dem Stützelement 4 bzw. der Lagermetallschicht 5 bzw. einer dazwischen angeordneten Diffusionssperrschicht oder Bindeschicht erfolgt aus der Gasphase, bevorzugt durch Sputtern. Da das Sputterverfahren an sich bereits aus dem Stand der Technik bekannt ist, sei hierzu auf den einschlägigen Stand der Technik betreffend die Ausbildung und Anordnung der Targets, die Anordnung der zu beschichtenden Bauteile in der Beschichtungskammer, etc, verwiesen.

Auch die Diffusionssperrschicht aus Stahl, insbesondere Edelstahl, wird bevorzugt aufgesputtert.

Die Lagermetallschicht 5 und/oder weitere Zwischenschichten können gegebenenfalls galvanisch abgeschieden sein bzw. ist es möglich, diese mittels Walzplattieren mit dem Stützelement 4 zu verbinden oder insbesondere diese mittels Gussverfahren, insbesondere dem horizontalen Strangguss, aufzubringen.

Auch diese Verfahren sind bereits ausreichend aus dem Stand der Technik dokumentiert, sodass sich eine weitere Erörterung an dieser Stelle erübrigt.

Für das Beimengen des zumindest einen Elementes, welches einen zumindest um 950 °C höheren Schmelzpunkt als Bismut aufweist, ist es möglich, aus diesen Elementen ein Target herzustellen bzw. besteht weiters die Möglichkeit, aus einer Vorlegierung mit Bismut oder mit Aluminium ein entsprechendes Target zu fertigen. Es können also Reinmetalle oder Vorlegierungen im Rahmen der Erfindung verwendet werden.

Es ist weiters möglich, dass mehrere, beispielsweise zwei, drei oder vier, der oben erwähnten Elemente mit dem höheren Schmelzpunkt in der Gleitschicht 6 enthalten sind und können hierfür wiederum entsprechende Vorlegierungen aus mehreren Elementen oder aber auch mehrere Einzeltargets verwendet werden. Diese Elemente sind bevorzugt metallisch und nicht radioaktiv.

Für diesen Fall besteht weiters die Möglichkeit, dass die einzelnen Targets, sofern mehrere Elemente in Form von jeweils einzelnen Targets verwendet werden, alternierend mit Energie beaufschlagt werden, sodass in der Gasphase unterschiedliche Konzentrationen an diesen Elementen alternierend vorhanden sind und somit sich primär diese Elemente Schichtweise auf dem Stützelement 4 bzw. der Lagermetallschicht 5 abscheiden, wobei gegebenenfalls ein Ausgleich von Konzentrationsschwankungen, sofern dies gewünscht ist und nicht ohnehin Konzentrationsgradienten in der Gleitschicht 6 an den einzelnen Elementen eingestellt werden, beispielsweise um unterschiedliche Härten im Bereich der Oberfläche der Gleitschicht, welche auf das zu lagernde Bauteil, z.B. eine Welle, weist und eine höhere Härte im Bereich der Lagermetallschicht 5, durch Diffusion aufgrund der Wärmebeanspruchung bei der Herstellung erfolgen kann.

Da die Versuche, die die Anmelderin im Rahmen der Erfindung durchgeführt hat, den Rahmen dieser Beschreibung sprengen würde, werden im Folgenden nur ausgesuchte Ausführungsbeispiele der Erfindung angegeben.
1. Ausführungsbeispiel:
   Es wurde ein Streifen aus Stahl mit einer Lagermetallschicht 5 aus gegossenem CuSn5Zn durch horizontalen Bandguss beschichtet und dieser Verbund anschließend in die Form einer Gleitlagerhalbschale umgeformt. Dieser Gleitlagerhalbschale wurde in der Folge in eine Beschichtungskammer einer Versuchsanlage überführt, die daraufhin evakuiert wurde. Gegebenenfalls kann die Beschichtungskammer nach dem Einschleusen der Gleitlagerhalbschale mehrmals mit Argon gespült und dazwischen evakuiert werden.

Nach dem Einschleusen wurde die Oberfläche durch inverses Sputtern mit Ar als Prozessgas gereinigt.

Als Target für das Aufsputtern der Gleitschicht 6 wurde ein, insbesondere pulvermetallurgisch hergestelltes, Legierungstarget aus Molybdän, Aluminium und Bismut verwendet. Folgende Parameter wurden für die Beschichtung verwendet.
Temperatur: 150 °C
Druck: 2.10⁻³ mbar
Leistung: 4 kW
Abscheiderate: 0,85 µm/Min

Die Gleitschicht 6 hatte die Endzusammensetzung AlBil5Mo2.

Es wurde eine Schichtdicke der Gleitschicht 6 von 16 µm hergestellt.

In einer Ausführungsvariante hierzu wurde auf der Lagermetallschicht 5 vor der Abscheidung der Gleitschicht 6 eine Zwischenschicht aus Edelstahl angeordnet.

Molybdän hat einen Schmelzpunkt von ca. 2620 °C, dieser liegt also deutlich höher als der Schmelzpunkt von Bismut, der ca. 271 °C beträgt. Durch diesen hohen Schmelzpunkt wird erreicht, dass das Molybdän praktisch keiner Diffusion in der Gleitschicht 6 während der Beschichtung unterliegt, sodass damit den darin anhaftenden Bismutatomen ebenfalls nur ein beschränkter Raum für die Diffusion zur Verfügung steht, also damit die Oberflächendiffusion des Bismuts behindert wird. Es wird damit in der Folge verhindert, dass sich mehrere Bismutatome - über die Zeit gesehen - zu größeren disperen Phasen verbinden, sondern bilden diese einzelnen Bismutkristallite bzw. Bismutatome Keime für weitere Bismutatome aus, wobei durch die Verhinderung der Diffusion sehr viele Keime - im Hinblick auf die Keimdichte sei auf obige Ausführungen verwiesen - zur Verfügung stehen und damit ein wesentlich feineres Gefüge hergestellt werden kann.

Einen zumindest annähernd gleichen Wirkungsmechanismus zeigen beispielsweise auch Kohlenstoff, insbesondere Diamant, mit einer Schmelztemperatur von ca. 3547 °C, Wolfram mit einer Schmelztemperatur von 3422 °C, Rhenium mit einer Schmelztemperatur von 3186 °C, Osmium mit einer Schmelztemperatur von 3033 °C, Tantal mit einer Schmelztemperatur von 3017 °C, Niob mit einer Schmelztemperatur von 2477 °C, Iridium mit einer Schmelztemperatur von 2446 °C, Ruthenium mit einer Schmelztemperatur von 2334 °C, Hafnium mit einer Schmelztemperatur von 2233 °C, Technetium mit einer Schmelztemperatur von 2157 °C. Aber auch mit anderen metallischen Elementen unterhalb von 2000 °C, beispielsweise Paladium oder Platin konnte dieser Effekt beobachtet werden, wobei beobachtet werden konnte, dass dieser Effekt größer ist bei den angegebenen metallischen Elementen, deren Schmelzpunkte um mindestens 1500 °C, bzw. zumindest annähernd 2000 °C höher liegt, als jener des Bismuts.

### 2. Ausführungsbeispiel

Mit Ausnahme der Gleitschicht 6 wurde derselbe Aufbau des Gleitlagerelementes 1 wie nach Ausführungsbeispiel 1 verwendet.

Anstelle von Molybdän wurde in diesem Fall Nickel als Legierungselement im Target verwendet, wobei in diesem Fall auch Kupfer verwendet wurde, um die Aluminiummatrix zu härten, wobei allerdings im Vergleich zu üblichen Konzentrationen an Kupfer aus dem Stand der Technik für diesen Zweck lediglich die Hälfte der Kupfermenge zugesetzt wurde und die andere Hälfte durch Nickel ersetzt wurde. Folgende Parameter wurden für die Beschichtung verwendet.
Temperatur: 150 °C
Druck: 2,5.10⁻³ mbar
Leistung: 4,5 kW
Abscheiderate: 0,8 µm/Min

Die Gleitschicht 6 hatte die Endzusammensetzung AlBi11Cu0,5Ni0,5

Es wurde eine Schichtdicke der Gleitschicht 6 von 20 µm hergestellt.

Bismut bildet mit Nickel beschränkt intermetallische Phasen, beispielsweise in NiBi bzw. NiBi3. Damit wird durch die Zugabe von Nickel bereits eine höhere Anzahl an möglichen Keimplätzen dem Bismut zur Ablagerung zur Verfügung gestellt, wodurch wiederum ein feineres Gefüge - im Hinblick auf die Korngrößen sei auf obige Ausführungen verwiesen - erzielt wird. Zudem wirkt Nickel für die Aluminiummatrix verstärkend, sodass also mit Nickel bzw. gleich wirkenden Elementen, wie beispielsweise Mangan, ein doppelter Effekt im Hinblick auf die Verschleißbeständigkeit der Gleitschicht 6 erreicht werden kann.

Es sei an dieser Stelle erwähnt, dass es im Rahmen der Erfindung möglich ist, beide Effekte entsprechend dem Ausführungsbeispiel 1 und 2 zu nutzen, also der Aluminiumbasislegierung sowohl ein sehr hochschmelzendes metallisches Element als auch ein Element, welches eine gewisse Affinität zu Bismut aufweist, zuzusetzen.

### 3. Ausführungsbeispiel

Zur Erhöhung der Keimdichte, um damit ein feineres Gefüge zu erhalten, wurde versuchsweise auch an das Substrat, d.h. das Stützelement 4, eine Bias-Spannung in der Höhe von -50 V angelegt, mit dem Hintergrund, während der Abscheidung von Aluminium und Bismut Gitterfehler zu erzeugen, wobei diese Gitterfehler aktive Zentren und somit Keimstellen bilden. Es wurden dabei folgende Parameter verwendet.
Temperatur: 175 °C
Druck: 2.10⁻³ mbar
Leistung: 4,5 kW
Abscheiderate: 0,8 µm/Min

Die Gleitschicht 6 hatte die Endzusammensetzung AlBi25Cu.

Es wurde damit eine Schichtdicke der Gleitschicht 6 von 15 µm hergestellt.

Wiederum sei erwähnt, dass es im Rahmen der Erfindung möglich ist, für die Herstellung eines Gleitlagerelementes 1, d.h. insbesondere eine Gleitschicht 6, alle drei Effekte entsprechend den Ausführungsbeispielen 1 bis 3 bzw. auch nur zwei Effekte entsprechend dem Ausführungsbeispiel 1 und 3 bzw. 2 und 3 zu nutzen.

Die Gleitschicht 6 bzw. der erfindungsgemäße Lageraufbau kann insbesondere für LKW-Lager verwendet werden.

Die Ausführungsbeispiele zeigen mögliche Ausführungsvarianten des Gleitlagerelementes 1. Der Ordnung halber sei abschließend darauf hingewiesen, dass zum besseren Verständnis des Aufbaus Gleitlagerelementes 1 dieses bzw. dessen Bestandteile teilweise unmaßstäblich und/ oder vergrößert und/oder verkleinert dargestellt wurden.

### Bezugszeichenaufstellung

- 1: Gleitlagerelement
- 2: Pleuellager
- 3: Pleuelauge
- 4: Stützelement
- 5: Lagermetallschicht

- 6: Gleitschicht

## Patentansprüche

1. Verfahren zur Herstellung eines Gleitlagerelementes (1) nach dem auf einem Stützelement (4) eine Gleitschicht (6) durch Gasphasenabscheidung, gegebenenfalls nach Anordnung von zumindest einer Zwischenschicht, erzeugt wird, wobei die Gleitschicht (6) eine Aluminiummatrix aufweist, in der neben Aluminium Bismut als Hauptbestandteil und gegebenenfalls Kupfer enthalten sind, jeweils mit den herstellungsbedingten Verunreinigungen der Elemente, wobei der Anteil an Bismut ausgewählt wird aus einem Bereich mit einer unteren Grenze von 10 Gew.-% und einer oberen Grenze von 45 Gew.-%, **dadurch gekennzeichnet, dass** durch Gasphasenabscheidung von zumindest einem Element, dessen Schmelzpunkt um zumindest 950 °C höher ist als jener des Bismuts und/oder durch Anlegen einer Bias-Spannung an das Stützelement die Bismut-Keimdichte erhöht wird, wobei das zumindest eine Element aus einer Gruppe umfassend Molybdän, Nickel, Chrom, Eisen, Hafnium, Kohlenstoff, Niob, Iridium, Osmium, Rhenium, Rhodium, Ruthenium, Tantal, Vanadium, Wolfram, Technetium und Titan ausgewählt wird.

2. Verfahren nach Anspruch 1, **dadurch gekennzeichnet, dass** die Bismut-Keimdichte auf einen Wert eingestellt wird, der ausgewählt ist aus einem Bereich mit einer unteren Grenze von 4.10⁶ Keime/cm² und einer oberen Grenze von 2,5.10⁹ Keime/cm².

3. Verfahren nach Anspruch 1 oder 2, **dadurch gekennzeichnet, dass** die Bias-Spannung am Stützelement ausgewählt ist aus einem Bereich mit einer unteren Grenze von -20 V und einer oberen Grenze von -150 V.

4. Verfahren nach einem der vorhergehenden Ansprüche, **dadurch gekennzeichnet, dass** das zumindest eine Element mit dem höheren Schmelzpunkt als Bismut der Gasphase gleichzeitig mit dem Bismut zugesetzt wird.

5. Verfahren nach einem der vorhergehenden Ansprüche, **dadurch gekennzeichnet, dass** das zumindest eine Element mit dem höheren Schmelzpunkt als Bismut in einer Konzentration der Gasphase zugesetzt wird, die ausgewählt ist aus einem Bereich mit einer unteren Grenze von 0,5 % und einer oberen Grenze von 10 %.

6. Verfahren nach einem der vorhergehenden Ansprüche, **dadurch gekennzeichnet, dass** das Kupfer zumindest teilweise durch das zumindest eine Element mit dem höheren Schmelzpunkt als Bismut ersetzt wird.

7. Gleitlagerelement (1) mit einem Stützelement (4), auf dem eine aus der Gasphase abgeschiedene Gleitschicht (6) und gegebenenfalls zwischen dem Stützelement (4) und der Gleitschicht zumindest eine Zwischenschicht angeordnet ist, wobei die Gleitschicht (6) eine Aluminiummatrix aufweist, in der neben Aluminium Bismut unter Ausbildung einer Bismut enthaltenden Phase als Hauptbestandteil in einem Anteil, der ausgewählt ist aus einem Bereich mit einer unteren Grenze von 10 Gew.-% und einer oberen Grenze von 45 Gew.-%, und gegebenenfalls Kupfer enthalten sind, jeweils mit den herstellungsbedingten Verunreinigungen der Elemente, wobei in der Aluminiummatrix zumindest ein Element, dessen Schmelzpunkt um zumindest 950 °C höher ist als jener des Bismuts, enthalten ist, **dadurch gekennzeichnet, dass** die Bismut enthaltende Phase eine Korngröße aufweist, die ausgewählt ist aus einem Bereich mit einer unteren Grenze von 50 nm und einer oberen Grenze von 3 µm und dass das zumindest eine Element aus einer Gruppe umfassend Molybdän, Nickel, Chrom, Eisen, Hafnium, Kohlenstoff, Niob, Iridium, Osmium, Rhenium, Rhodium, Ruthenium, Tantal, Vanadium, Wolfram, Technetium und Titan ausgewählt ist.

8. Gleitlagerelement (1) nach Anspruch 7, **dadurch gekennzeichnet, dass** der Anteil an Kupfer ausgewählt ist aus einem Bereich mit einer unteren Grenze von 0,5 Gew.-% und einer oberen Grenze von 5 Gew.-%.

9. Gleitlagerelement (1) nach Anspruch 7 oder 8, **dadurch gekennzeichnet, dass** der Anteil an dem zumindest einen Element ausgewählt ist aus einem Bereich mit einer unteren Grenze von 0,5 Gew.-% und einer oberen Grenze von 10 Gew.-%, mit der Maßgabe, dass die Summe an mehreren Elementen aus dieser Gruppe nicht mehr als 15 Gew.-% beträgt.

10. Gleitlagerelement (1) nach einem der Ansprüche 7 bis 9, **dadurch gekennzeichnet, dass** die Gleitschicht (6) eine Schichtdicke aufweist, die ausgewählt ist aus einem Bereich mit einer unter Grenze von mindestens 10 µm und einer oberen Grenze von maximal 150 µm.

11. Gleitlagerelement (1) nach einem der Ansprüche 7 bis 10, **dadurch gekennzeichnet, dass** die Gleitschicht (6) eine Härte nach Vickers aufweist, ausgewählt aus einem Bereich mit einer unteren Grenze von 50 UMHV(3 pond) und einer oberen Grenze von 250 UMHV(3 pond).

12. Gleitlagerelement (1) nach einem der Ansprüche 7 bis 11, **dadurch gekennzeichnet, dass** auf dem Stützelement (4) eine Lagermetallschicht (5) und über dieser die Gleitschicht (6) und zwischen der Lagermetallschicht (5) und der Gleitschicht (6) eine Diffusionssperrschicht aus Stahl, insbesondere Edelstahl, angeordnet sind.

## Claims

1. A method for producing a sliding bearing element (1), in which a sliding layer (6) is produced on a support element (4) by vapour-phase deposition, optionally after positioning at least one intermediate layer, wherein the sliding layer (6) comprises an aluminium matrix which, in addition to aluminium, contains bismuth as a major component and optionally copper, respectively with unavoidable impurities in the elements dictated by the production conditions, wherein the proportion of bismuth is selected from a range with a lower limit of 10 % by weight and an upper limit of 45 % by weight, **characterized in that** the nuclear density of the bismuth is increased by means of vapour-phase deposition of at least one element with a melting point which is at least 950 °C higher than that of bismuth and/or by applying a bias voltage to the support element, wherein the at least one element is selected from a group comprising molybdenum, nickel, chromium, iron, hafnium, carbon, niobium, iridium, osmium, rhenium, rhodium, ruthenium, tantalum, vanadium, tungsten, technetium and titanium.

2. The method according to claim 1, **characterized in that** the nuclear density of the bismuth is set at a value selected from a range with a lower limit of 4 x 10⁶ nuclei/cm² and an upper limit of 2.5 x 10⁹ nuclei/cm².

3. The method according to claim 1 or 2, **characterized in that** the bias voltage at the support element is selected from a range with a lower limit of -20 V and an upper limit of -150 V.

4. The method according to any one of the preceding claims, **characterized in that** the at least one element which has a higher melting point than bismuth is added to the vapour phase at the same time as the bismuth.

5. The method according to any one of the preceding claims, **characterized in that** the at least one element which has a higher melting point than bismuth is added to the vapour phase in a concentration selected from a range with a lower limit of 0.5 % and an upper limit of 10 %.

6. The method according to any one of the preceding claims, **characterized in that** the copper is at least partially replaced by the at least one element which has a higher melting point than bismuth.

7. A sliding bearing element (1) with a support element (4), on which a sliding layer (6) deposited from the vapour phase is disposed and optionally at least one intermediate layer is disposed between the support element (4) and the sliding layer, wherein the sliding layer (6) comprises an aluminium matrix which, in addition to aluminium, contains bismuth with the formation of a bismuth-containing phase as the major component in a proportion which is selected from a range with a lower limit of 10 % by weight and an upper limit of 45 % by weight, and optionally copper, respectively with unavoidable impurities in the elements dictated by the production conditions, wherein the aluminium matrix contains at least one element which has a melting point which is at least 950 °C higher than that of bismuth, **characterized in that** the bismuth-containing phase has a grain size which is selected from a range with a lower limit of 50 nm and an upper limit of 3 µm, and **in that** the at least one element is selected from a group comprising molybdenum, nickel, chromium, iron, hafnium, carbon, niobium, iridium, osmium, rhenium, rhodium, ruthenium, tantalum, vanadium, tungsten, technetium and titanium.

8. The sliding bearing element (1) according to claim 7, **characterized in that** the proportion of copper is selected from a range with a lower limit of 0.5 % by weight and an upper limit of 5 % by weight.

9. The sliding bearing element (1) according to claim 7 or 8, **characterized in that** the proportion of the at least one element is selected from a range with a lower limit of 0.5 % by weight and an upper limit of 10 % by weight, with the proviso that the sum of several elements from this group is no more than 15 % by weight.

10. The sliding bearing element (1) according to any one of claims 7 to 9, **characterized in that** the sliding layer (6) has a layer thickness which is selected from a range with a lower limit of at least 10 µm and an upper limit of a maximum of 150 µm.

11. The sliding bearing element (1) according to any one of claims 7 to 10, **characterized in that** the sliding layer (6) has a Vickers hardness selected from a range with a lower limit of 50 UMHV(3 pond) and an upper limit of 250 UMHV(3 pond).

12. The sliding bearing element (1) according to any one of claims 7 to 11, **characterized in that** a bearing metal layer (5) is disposed on the support element (4) and the sliding layer (6) is disposed over the bearing metal layer (5) and a diffusion barrier layer produced from steel, in particular high-quality steel, is disposed between the bearing metal layer (5) and the sliding layer (6).

## Revendications

1. Procédé de fabrication d'un élément de palier lisse (1), selon lequel, sur un élément d'appui (4), une couche de glissement (6) est produite par dépôt en phase gazeuse, le cas échéant après le dépôt d'au moins une couche intermédiaire, la couche de glissement (6) comprenant une matrice d'aluminium dans laquelle, en plus de l'aluminium, sont également contenus du bismuth en tant que composant principal et, le cas échéant, du cuivre, chacun avec les impuretés des éléments dus à la fabrication, la part de bismuth étant sélectionnée dans un intervalle avec une limite inférieure de 10 % en poids et une limite supérieur de 45 % en poids, **caractérisé en ce que** le dépôt en phase gazeuse d'au moins un élément dont le point de fusion est d'au moins 950°c plus élevé que celui du bismuth et/ou l'application d'une tension de polarisation à l'élément d'appui permet d'augmenter la densité de germes du bismuth, l'au moins un élément étant sélectionné dans un groupe comprenant le molybdène, le nickel, le chrome, le fer, le hafnium, le carbone, le niobium, l'iridium, l'osmium, le rhénium, le rhodium, le ruthénium, le tantale, le vanadium, le tungstène, le technétium et le titane.

2. Procédé selon la revendication 1, **caractérisé en ce que** la densité de germes du bismuth est ajustée à une valeur qui est sélectionnée dans un intervalle avec une limite inférieure de 4.10⁶ germes/cm² et une limite supérieure de 2,5.10⁹ germes/cm².

3. Procédé selon la revendication 1 ou 2, **caractérisé en ce que** la tension de polarisation appliquée à l'élément d'appui est sélectionnée dans un intervalle avec une limite inférieure de -20 V et une limite supérieure de -150 V.

4. Procédé selon l'une des revendications précédentes, **caractérisé en ce que** l'au moins un élément avec le point de fusion plus élevé que celui du bismuth de la phase gazeuse est ajouté en même temps que le bismuth.

5. Procédé selon l'une des revendications précédentes, **caractérisé en ce que** l'au moins un élément avec le point de fusion plus élevé que celui du bismuth est ajouté avec une concentration de phase gazeuse qui est sélectionnée dans un intervalle avec une limite inférieure de 0,5 % et une limite supérieure de 10 %.

6. Procédé selon l'une des revendications précédentes, **caractérisé en ce que** le cuivre est remplacé au moins partiellement par l'au moins un élément avec le point de fusion plus élevé que celui du bismuth.

7. Élément de palier lisse (1) avec un élément d'appui (4) sur lequel est disposée une couche de glissement (6) déposée en phase gazeuse et, le cas échéant, entre l'élément d'appui (4) et la couche de glissement, au moins une couche intermédiaire, la couche de glissement (6) comprenant une matrice d'aluminium dans laquelle, en plus de l'aluminium, sont également contenus du bismuth, grâce à la formation d'une phase contenant du bismuth en tant que composant principal, avec une proportion qui est sélectionné dans un intervalle avec une limite inférieure de 10 % en poids et une limite supérieure de 45 % en poids et, le cas échéant, du cuivre, chacun avec les impuretés des éléments dus à la fabrication, la matrice d'aluminium contenant au moins un élément dont le point de fusion est d'au moins 950°c plus élevé que celui du bismuth, **caractérisé en ce que** la phase contenant le bismuth présente une taille de grain qui est sélectionnée dans un intervalle avec une limite inférieure de 50 nm et une limite supérieure de 3 µm et **en ce que** l'au moins un élément est sélectionné dans un groupe comprenant le molybdène, le nickel, le chrome, le fer, le hafnium, le carbone, le niobium, l'iridium, l'osmium, le rhénium, le rhodium, le ruthénium, le tantale, le vanadium, le tungstène, le technétium et le titane.

8. Élément de palier lisse (1) selon la revendication 7, **caractérisé en ce que** la part de cuivre est sélectionné dans un intervalle avec une limite inférieure de 0,5 % en poids et une limite supérieure de 5 % en poids.

9. Élément de palier lisse (1) selon la revendication 7 ou 8, **caractérisé en ce que** la part de l'au moins un élément est sélectionnée dans un intervalle avec une limite inférieure de 0,5 % en poids et une limite supérieure de 10 % en poids avec pour règle que la somme de plusieurs éléments de ce groupe ne fasse pas plus de 15 % en poids.

10. Élément de palier lisse (1) selon l'une des revendications 7 à 9, **caractérisé en ce que** la couche de glissement (6) présente une épaisseur qui est sélectionnée dans un intervalle avec une limite inférieure d'au moins 10 µm et une limite supérieure de 150 µm maximum.

11. Élément de palier lisse (1) selon l'une des revendications 7 à 10, **caractérisé en ce que** la couche de glissement (6) présente une dureté Vickers sélectionnée dans un intervalle avec une limite inférieure de 50 UMHV (3 pond) et une limite supérieure de 250 UMHV (3 pond).

12. Élément de palier lisse (1) selon l'une des revendications 7 à 11, **caractérisé en ce que**, sur l'élément d'appui (4) sont disposées une couche métallique de palier (5) et, au-dessus de celle-ci, la couche de glissement (6) et, entre la couche métallique de palier (5) et la couche de glissement (6), une couche de blocage de diffusion en acier, plus particulièrement en acier inoxydable.
